# FASCICULE DE BREVET EUROPEEN

(11) **EP 2 839 488 B1**
(45) Date de publication et mention de la délivrance du brevet: **26.09.2018**
(21) Numéro de dépôt: 13715702.0
(22) Date de dépôt: 15.04.2013
(51) Int. Cl.: H01F 10/00, H01F 10/32, H01F 41/32

(54) **DISPOSITIF INJECTEUR DE SPINS COMPORTANT UNE COUCHE DE PROTECTION EN SON CENTRE**
BAUTEIL FÜR SPININJEKTION MIT EINER ZENTRALEN SCHUTZSCHICHT
SPIN INJECTION DEVICE HAVING PROTECTION LAYER AT ITS CENTER

(30) Priorité: 18.04.2012 FR 1253569
(43) Date de publication de la demande: 25.02.2015
(73) Titulaire: Centre National de la Recherche Scientifique, 75016 Paris (FR); Université de Strasbourg, 67081 Strasbourg cedex (FR)
(72) Inventeur: BOWEN, Martin, 77694 Kehl (DE); ALOUANI, Mébarek, 67202 Wolfisheim (FR); BOUKARI, Samy, 68180 Horbourg-Wihr (FR); BEAUREPAIRE, Eric, 67550 Vendenheim (FR); WEBER, Wolfgang, 77694 Kehl (DE); SCHEURER, Fabrice, 67370 Behlenheim (FR); JOLY, Loïc, 67205 Oberhausbergen (FR)
(74) Mandataire: Lavoix
(86) Numéro de dépôt international: PCT/EP2013/057769
(87) Numéro de publication internationale: WO 2013/156426

(56) Documents cités:
- WO-A2-2006/022859
- US-B1- 6 852 555
- ARISTOV V YU ET AL: "Ferromagnetic cobalt and iron top contacts on an organic semiconductor: Evidence for a reacted interface", ORGANIC ELECTRONICS, ELSEVIER, AMSTERDAM, NL, vol. 10, no. 1, 1 février 2009 (2009-02-01), pages 8-11, XP025845798, ISSN: 1566-1199, DOI: 10.1016/J.ORGEL.2008.09.001 [extrait le 2008-09-12]
- SANTOS T S ET AL: "Room-temperature tunnel magnetoresistance and spin-polarized tunneling through an organic semiconductor barrier", PHYSICAL REVIEW LETTERS, AMERICAN PHYSICAL SOCIETY, NEW YORK, US, vol. 98, no. 1, 5 janvier 2007 (2007-01-05), pages 16601/1-4, XP002474246, ISSN: 0031-9007 cité dans la demande
- BERGENTI I ET AL: "Transparent manganite films as hole injectors for organic light emitting diodes", JOURNAL OF LUMINESCENCE, ELSEVIER BV NORTH-HOLLAND, NL, vol. 110, no. 4, 10 décembre 2004 (2004-12-10), pages 384-388, XP004674689, ISSN: 0022-2313, DOI: 10.1016/J.JLUMIN.2004.08.036

## Description

### DOMAINE TECHNIQUE

La présente demande concerne le domaine technique de l'électronique, plus précisément celui de la spintronique. L'invention concerne notamment un procédé de fabrication d'un dispositif injecteur de spins, permettant de filtrer les électrons le traversant, en fonction de l'orientation de leur spin.

### ÉTAT DE LA TECHNIQUE ANTÉRIEURE

Les progrès technologiques effectués dans l'industrie des semi-conducteurs ont permis de diminuer fortement les dimensions des dispositifs électroniques, augmentant ainsi leur puissance et leur complexité. Aujourd'hui, la réalisation de ces dispositifs à l'échelle atomique fait face à de nouvelles difficultés, notamment liées aux phénomènes physiques se produisant à cette échelle. Pour continuer à accroître les performances des semi-conducteurs, il est donc nécessaire de développer des dispositifs basés sur de nouveaux concepts.

Un de ces concepts consiste à exploiter la propriété quantique du spin des électrons, dans le but de stocker de l'information. C'est le domaine technique de la spintronique.

Les électrons sont caractérisés par plusieurs valeurs intrinsèques, notamment par leur moment cinétique ou « spin » en anglais. En raison du principe d'incertitude des mesures à l'échelle atomique, la mesure du spin d'un électron n'est possible que selon une seule observable ou direction, et sa valeur peut être positive ou négative. Ces états sont nommés respectivement « spin up » et « spin down ».

Pour exploiter cette caractéristique au niveau industriel, il est nécessaire de développer des dispositifs capables de sélectionner et/ou de lire l'état de polarisation des spins des électrons. Les dispositifs permettant de sélectionner ou de filtrer les électrons en fonction de l'orientation de leur spin, sont nommés dispositifs injecteurs de spins.

Actuellement, plusieurs dispositifs injecteurs de spins sont en cours de développement. Certains injecteurs de spins exploitent l'effet tunnel pour filtrer les électrons. Cet effet est observé lorsque une barrière, dite barrière tunnel, est interposée entre deux éléments conducteurs. Physiquement, la barrière tunnel est un milieu peu favorable à la diffusion des électrons. Ce milieu peut donc être isolant ou semiconducteur.

Les propriétés quantiques, comme par exemple l'orientation en spin d'une particule, se déplaçant entre deux conducteurs par effet tunnel, sont conservées lors de ce transport. Il est alors possible d'utiliser cette propriété pour transporter de l'information entre deux éléments conducteurs ferromagnétiques. L'état de polarisation des électrons, permettant de coder de l'information, peut alors être détecté à l'aide d'un conducteur ferromagnétique placé de l'autre côté de la barrière tunnel, l'ensemble formant une jonction tunnel magnétique. En plaçant le dispositif dans un état d'alignement parallèle ou antiparallèle de l'aimantation des deux couches ferromagnétiques, il est ainsi possible de mesurer le degré de polarisation de spin du courant traversant le dispositif. Puisque le courant part d'une électrode en direction de l'autre, les fonctions de polarisation en spin de courant et de détection de cette polarisation (ou « lecture ») sont attribuées à chacune des deux interfaces de la jonction tunnel magnétique en fonction du signe du courant. On peut alors inverser l'attribution de polarisation et de détection de spin du courant aux interfaces simplement en changeant le signe du courant traversant le dispositif (Fert, Nobel Lectures 2008 Angew. Chem. Int. Ed.2008, 47, 5956 - 5967).

Les capacités de polarisation en spins d'une jonction tunnel magnétique peuvent être décuplées en sélectionnant une barrière tunnel de structure électronique appropriée à celle des électrodes ferromagnétiques adjacentes. Dans ce cas, certaines fonctions d'onde d'électrons de conduction fortement polarisées en spin au sein de la couche ferromagnétique traverseront plus facilement la barrière, ce qui aboutit à un courant fortement polarisé en spin (Bowen PHYSICAL REVIEW B 73, 140408R (2006)). Cet effet a par exemple été observé en interposant une couche d'oxyde de magnésium entre deux couches d'alliage de fer (Appl. Phys. Lett. 90, 212507 (2007)).

Une autre voie de développement porte sur l'utilisation d'une couche organique en tant que barrière tunnel (Physical Review Letter 98, 016601(2007)). Les matériaux organiques, du fait de leur faible masse ou numéro atomique, comparée à celle des matériaux inorganiques, offrent l'avantage de faiblement interagir avec l'état de polarisation des électrons de conduction. Ainsi, leurs spins sont bien moins perturbés lorsqu'ils traversent ce type de matériau. Ces matériaux semblent donc très prometteurs pour de futurs applications, tels que des dispositifs injecteur de spins polarisés (Nature 427 821 (2004)).

De récentes études ont montré qu'un phénomène de couplage est nécessaire au niveau desdites interfaces, pour permettre la transmission de spins polarisés entre un milieu magnétique et une couche organique (Nature Material 6, 516(2007), Physical Review Letter 105, 077201(2010)). Or, les propriétés de transmission peuvent être rapidement dégradées lorsque les interfaces comportent des impuretés et/ou sont oxydées. Plus précisément, lorsque les surfaces sont oxydées, le degré d'ordre des spins peut être diminué, voire éliminé, car les électrodes ferromagnétiques à base de métaux de transition, peuvent former au contact de l'oxygène présent dans l'air, des oxydes aux propriétés antiferromagnétiques désordonnées. Dans le domaine de la spintronique inorganique, ceci peut conduire à une diminution, voire à la disparition, des performances spintroniques du dispositif (Physical Review B79, 224405 (2009)). C'est l'une des causes limitant l'utilisation de ce type de dispositif au niveau industriel.

Le brevet WO 2006/022859 A2 et la publication ARISTOV V YU ET AL., ORGANIC ELECTRONICS, vol. 10, pages 8-11, présentent tout deux un dispositif spintronique comportant une couche de matériau organique. Actuellement, afin de prévenir ce phénomène d'oxydation, une solution consiste à réaliser le dépôt de la couche organique, sur le substrat magnétique, dans un environnement à atmosphère contrôlée ou non oxydante, comme par exemple dans une atmosphère sous vide. On notera ici que même l'environnement d'une boite à gants, contenant par exemple une partie par million d'oxygène et/ou d'eau, peut dégrader les propriétés spintronique d'une couche ferromagnétique.

Par ailleurs, seul un sous-ensemble limité de molécules peut être sublimé sous vide, tandis qu'un vaste ensemble de molécules ne peut être conditionné que sous forme humide, par exemple par trempage (ou « dip-coating » en anglais, ou centrifugation (ou « spin-coating » en anglais)...

Un autre inconvénient réside dans le fait que la composition des couches organiques déposées ne doit pas contenir d'éléments susceptibles d'interagir avec la couche magnétique, de manière à dégrader ses propriétés spintroniques. Parmi ces éléments, l'oxygène peut être mentionné. Celui-ci peut, sous certaines formes, dégrader les propriétés spintroniques en formant des oxydes de métaux de transition non-ordonnés aux propriétés antiferromagnétiques. Ces éléments exclus entrent dans la composition de très nombreux composés organiques. De ce fait, les techniques actuelles d'élaboration sont restreintes à certaines compositions uniquement.

C'est pour cela, entre autre, que les dispositifs injecteurs de spins, comportant une couche organique sur une couche magnétique, sont délicats à assembler, en raison de contraintes sur l'environnement d'élaboration et restreignant de ce fait le type de molécule dans la classe de molécules sublimables sous vide.

L'un des objectifs de la présente demande est de permettre la fabrication de dispositifs injecteurs de spins, comportant une couche organique :
- dans des environnements moins contraignants ;
- et/ou avec des couches organiques n'excluant pas d'élément chimique aussi commun que l'oxygène, en raison du risque potentiel d'oxydation ;
- et/ou sans oxyder ou contaminer la face magnétique en vis-à-vis de la couche organique ;
- dont le taux de filtrage en spins est amélioré.

### EXPOSÉ DE L'INVENTION

L'invention a pour objet de résoudre au moins l'un des problèmes précédents.

Pour cela, il est proposé un procédé de réalisation d'un dispositif injecteur de spins, selon les étapes suivantes :
a) formation d'une couche de protection sur une face ou une première face d'un substrat, de manière à limiter ou empêcher l'oxydation et/ou la contamination de ladite face par son environnement, la face peut être magnétique et conduire le courant électrique, la couche de protection peut être diamagnétique ou paramagnétique ; de préférence, la couche de protection est paramagnétique et comporte une forte susceptibilité magnétique ;
b) formation d'une couche supérieure sur la couche de protection, favorisant le transfert d'électrons polarisés entre ladite couche et la face du substrat.

La présente invention propose en outre un procédé de réalisation d'un dispositif injecteur de spins, comportant les étapes suivantes :
a) formation d'une couche de protection métallique sur une face d'un substrat, de manière à limiter ou empêcher l'oxydation et/ou la contamination de ladite face par son environnement, la face du substrat étant magnétique et conduisant le courant électrique, la couche de protection étant par nature diamagnétique ou paramagnétique ;
b) formation d'une couche supérieure sur la couche de protection, apte à favoriser une polarisation en spin d'états électroniques au voisinage du niveau de Fermi de l'interface entre la couche de protection et la couche supérieure selon une amplitude et un référentiel de spin définis par le magnétisme du substrat et/ou de la face du substrat, la couche supérieure étant une couche organique dont un ou plusieurs sites moléculaires présentent, au contact avec la couche de protection, un moment paramagnétique caractérisé par un référentiel magnétique unique, figé dans l'espace et le temps et calqué sur, ou correspondant à, un référentiel magnétique du substrat et/ou de la face du substrat.

La couche de protection est une couche dont la composition et la structure ne sont pas ou bien très peu influencées par l'air et l'eau, présents dans l'atmosphère en contact avec la dite couche de protection. La couche de protection peut être métallique, et par exemple composée d'un ou plusieurs métaux nobles, ou par exemple par un ou plusieurs des éléments suivants : cuivre, argent, or. Le magnétisme du substrat peut alors donner naissance à un magnétisme porté par les atomes de l'interface couche de protection / couche supérieure, grâce à un mécanisme du couplage d'échange indirect magnétique. Il s'ensuit de fait une polarisation de spin des électrons autour du niveau de Fermi de ces atomes de l'interface couche de protection / couche supérieure, c'est-à-dire une polarisation de spin du courant destiné à passer à travers cette interface.

La physique du couplage d'échange indirect, qui s'apparente à un mécanisme permettant la projection du magnétisme issu du substrat à travers une couche non-magnétique, ici la couche de protection, opère en principe qu'il s'agisse d'une couche de protection métallique ou isolante ou encore semi-conductrice. Cependant, alors que l'effet sera à dominante oscillatoire dans le cas d'une couche métallique, il sera à dominante fortement évanescente (c'est-à-dire exponentiellement décroissante) dans le cas d'une couche isolante ou semi-conductrice. Le couplage d'échange obtenu à travers la couche de protection métallique est donc bien meilleur en termes d'amplitude (environ 10⁹ fois supérieur) et d'intensité qu'à travers une couche isolante ou semi-conductrice, notamment en considérant des couches d'épaisseurs supérieures à une monocouche (environ 0,18 nm pour une monocouche de cuivre).

Le moment paramagnétique présenté par le ou les sites moléculaires de la couche supérieure, au contact avec la couche de protection, peut être vu comme comportant un ordre magnétique à longue portée induit par le magnétisme du substrat, ou encore un ordre magnétique s'apparentant à du ferromagnétisme. Un ordre magnétique à longue portée peut être défini par une distance supérieure aux distances séparant les premiers, ou les seconds, ou les troisièmes atomes voisins, entourant un atome présent au niveau du ou des sites moléculaires.

L'épaisseur de la couche de protection, selon une direction sensiblement perpendiculaire ou perpendiculaire à la première face du substrat, peut être comprise entre une et cent trente épaisseurs d'une couche d'atomes composant ladite couche de protection, mais puisque le champ d'échange diminue lorsque cette épaisseur augmente (Nanomagnetism: Ultrathin Films, Multilayers and Nanostructures Vol 1 Chap. 3 p. 61 (2006)), il est préférable que l'épaisseur de la couche de protection demeure faible. Elle peut par exemple être comprise entre une et sept épaisseurs d'une couche d'atome composant la couche de protection. Une couche d'atome comporte un seul atome dans la direction de son épaisseur.

La couche supérieure peut être une couche organique ou une couche comportant, par exemple, un ou plusieurs des éléments suivants : carbone, azote, oxygène, fluor, bore, fer, cobalt, manganèse, cuivre, vanadium, zinc, magnésium, silicium, etc. La couche supérieure peut également comporter au moins l'un des éléments suivants : soufre, hydrogène, aluminium, potassium, chlore, sodium.

La couche de protection peut être de nature isolante ou semi-conductrice.

Il est préférable qu'un champ magnétique d'échange direct de l'ordre de 1000T puisse s'établir entre le substrat et la couche supérieure lorsque celles-ci sont en contact, afin de polariser au moins un site initialement non-magnétique au niveau de la couche supérieure (ex : un site de carbone). Le champ magnétique d'échange traversant la couche de protection peut ne pas dépasser une valeur de l'ordre de 2T. Il peut alors être préférable que la couche supérieure comporte au moins un élément présentant au moins un moment paramagnétique non-nul, tout au moins après l'adsorption de la couche supérieure sur la couche de protection. De préférence, le moment du ou des sites moléculaires paramagnétiques peuvent être saturés à au moins 50%, par le champ magnétique d'échange indirect entre le substrat et la couche supérieure. Afin d'amplifier ce champ d'échange à l'interface entre la couche de protection et la couche supérieure, l'épaisseur de la couche de protection peut être soigneusement contrôlée selon la structure électronique de celle-ci (voir ci-après et exposé détaillé).

La couche supérieure peut être une couche organique dont un ou plusieurs sites moléculaires présentent, au contact avec la couche de protection, un moment paramagnétique. Un ordre magnétique peut alors être induit par un couplage d'échange indirect se produisant entre la couche supérieure et le substrat via la couche de protection. Cet ordre magnétique est collectif à l'ensemble des atomes des molécules formant l'interface entre la couche supérieure et la couche de protection. Ceci peut donner lieu, si un courant traverse le dispositif injecteur de spins et grâce à l'alignement ferromagnétique du plan moléculaire (formé par ledit ou lesdits sites moléculaires) avec la face magnétique du substrat résultant de ce couplage d'échange, à une polarisation en spin importante de ce courant traversant ce plan moléculaire.

De part l'ordre magnétique collectif décrit ci-dessus, le moment paramagnétique de chaque atome de la couche organique qui est au contact avec la couche de protection peut être aligné selon le référentiel magnétique du matériau magnétique du substrat grâce au couplage d'échange indirect entre le substrat et la couche supérieure. Ainsi, lorsque le substrat comporte un matériau ferromagnétique, le moment magnétique induit sur ledit ou lesdits sites moléculaires acquiert une propriété ferromagnétique (par ferromagnétisme induit). On peut alors obtenir un courant polarisé en spin émanant de l'interface couche de protection / couche supérieure.

Le procédé de réalisation du dispositif injecteur de spins peut comporter en outre la réalisation de moyens de contrôle du magnétisme du substrat et/ou de la face du substrat. De tels moyens peuvent permettre de contrôler le référentiel (intensité) magnétique, et ainsi le référentiel (polarisation) de spin de la couche moléculaire (couche supérieure), en agissant sur le référentiel (intensité) magnétique du substrat. Ceci peut par exemple s'accomplir via des moyens permettant d'appliquer au substrat un champ magnétique, électrique, électro-magnétique, une dilatation et/ou contraction mécanique du substrat, ou encore un changement de température du substrat magnétique.

La première face du substrat peut être ferromagnétique et/ou ferrimagnétique et/ou antiferromagnétique et composée, sans exclusion, par l'un des éléments suivants : cobalt, et/ou nickel, et/ou fer, et/ou un alliage de Fer ou de Cobalt avec des métaux de type 4d ou/et 5d tels que le palladium et/ou le platine, et/ou un ou plusieurs oxydes magnétiques tels que Fe₃O₄ ou TiO₍₂₋ₓ₎. Ladite première face peut être cristallisée ou de structure cristalline, par exemple Co cfc(001), Fe cc(001), de façon à permettre la croissance sur celle-ci de couches de protection de structure cristalline compatible.

Lorsque le substrat et la couche de protection sont cristallisées, il est possible de soigneusement choisir l'épaisseur de la couche de protection pour, grâce à la formation d'un état de puits quantique au sein de la couche de protection, mieux projeter la densité d'états polarisée en spin, de la première face du substrat, sur la face opposée de la couche de protection, au contact avec la couche supérieure que l'on souhaite polariser en spin.

Cette condition de cristallisation n'est pas limitative. Dès lors que la première face du substrat est ferromagnétique, le substrat ou/et sa première face peuvent être amorphes, de même que la couche de protection.

De préférence, des liaisons chimiques s'établissent entre la couche de protection et la couche supérieure afin de mieux imprimer le champ d'échange indirect, et/ou la densité d'état polarisée en spin provenant de l'état quantifie dans la couche de protection, sur les sites atomiques du premier plan d'atomes de la couche supérieure.

Avantageusement, la couche de protection est métallique, ce qui permet de fabriquer des dispositifs faiblement résistifs, par exemple à des fins de nanotechnologie.

Avantageusement, la couche de protection permet à la première face du substrat de modifier et de contrôler, les propriétés magnétiques des atomes composant la première couche d'atomes de la couche supérieure, en contact avec ladite couche de protection. Cette influence peut éventuellement s'étendre dans la couche supérieure, à des couches plus profondes.

Avantageusement, le substrat peut comporter du cobalt, la couche de protection peut comporter du cuivre, et la couche supérieure peut comporter du MnPc. Dans une telle configuration, les sites atomiques des molécules de la couche supérieure (non seulement le Mn mais également le C et le N du Pc) ont alors leurs moments paramagnétiques caractérisés par un ordre magnétique collectif induit par l'échange indirect entre le matériau de la couche supérieure et celui du substrat via le Cu de la couche de protection, et cela notamment à température ambiante et avec un champ magnétique externe nul. De ce ferromagnétisme effectif de ces sites atomiques résulte une polarisation de spin moyenne au niveau de Fermi non-nulle.

Le procédé peut comporter en outre la réalisation de moyens de contrôle du magnétisme du substrat et/ou de la face du substrat. De tels moyens de contrôle permettent, via le contrôle du magnétisme du substrat et/ou de la face du substrat, de contrôler le magnétisme de l'interface entre la couche de protection et la couche de protection.

Selon une variante, le substrat du dispositif injecteur de spin peut être connecté ou attaché à un dispositif intermédiaire. Ce dernier peut être composé d'une couche de protection en contact ou sur un substrat, tel que précédemment décrit. Ces deux dispositifs peuvent être liés entre eux par l'intermédiaire de la couche de protection du dispositif intermédiaire.

La présente invention concerne donc également un procédé de réalisation d'un dispositif comportant la mise en oeuvre d'un procédé de réalisation d'un dispositif injecteur de spins selon l'invention, et dans lequel le dispositif injecteur de spin peut être connecté à un dispositif intermédiaire comportant une deuxième couche de protection disposée sur un deuxième substrat, la deuxième couche de protection du dispositif intermédiaire pouvant être disposée contre le substrat ou la couche supérieure du dispositif injecteur de spin. Cette configuration offre l'avantage de pouvoir contrôler la polarisation en spin du courant électrique traversant le dispositif injecteur de spins, mais aussi faire précesser le référentiel de spin de la couche supérieure à une fréquence dans la gamme des gigahertz.

Selon une autre variante, la couche supérieure d'un dispositif injecteur de spin tel que décrit ci-dessus, peut être connectée ou attachée à la couche de protection d'un dispositif intermédiaire précédent.

Les couches externes et opposées des dispositifs précédents peuvent être connectées à un dispositif générateur de courant.

Le dispositif générateur de courant peut être apte à délivrer un courant électrique polarisé destiné à traverser au moins la couche de protection du dispositif injecteur de spins en étant polarisé à au moins 10%, voir même des valeurs supérieures à environ 20%, pour une température de fonctionnement supérieure à -50°C. Celui-ci peut donc être mis en marche de manière à ce qu'un courant électrique traverse au moins la couche de protection du dispositif d'injecteur de spins. Le courant sortant du dispositif peut être polarisé à au moins 5% ou à au moins 10% ou à au moins 20%, selon une même direction et un même sens, et pour une température de fonctionnement du dispositif supérieure à -50°C et/ou -20°C, et/ou 0°C, et/ou 50°C, et/ou 150°C et/ou 250°c, et/ou 500°C.

La présente demande concerne également des dispositifs injecteurs de spins comportant :
- un substrat comportant une face ou première face magnétique et conduisant le courant électrique ;
- une couche de protection sur la face du substrat, de manière à limiter ou empêcher l'oxydation et/ou la contamination de ladite face par son environnement, la couche de protection peut être par nature faiblement magnétique ou diamagnétique ou paramagnétique ;
- une couche supérieure sur la couche de protection, favorisant le transfert d'électrons polarisés entre ladite couche et la première face du substrat.

Le substrat peut être connecté ou lié à un dispositif intermédiaire, tel que décrit précédemment, par la couche intermédiaire ou le substrat dudit dispositif intermédiaire.

Les couches externes et opposées des dispositifs précédents peuvent être connectées à un dispositif générateur de courant.

### BRÈVE DESCRIPTION DES DESSINS

D'autres détails et caractéristiques de l'invention apparaîtront de la description qui va suivre, faite en regard des figures annexées suivantes. Les parties identiques, similaires ou équivalentes des différentes figures portent les mêmes références de façon à faciliter le passage d'une figure à une autre. Les différentes parties représentées sur les figures ne le sont pas nécessairement selon une échelle uniforme, pour rendre les figures plus lisibles. Les repères indiqués sur les figures sont orthogonaux.
La figure 1 représente une étape d'élaboration d'un dispositif injecteur de spins.
La figure 2 représente un dispositif injecteur de spins.
La figure 3 représente une première variante d'un dispositif injecteur de spins.
La figure 4 représente une seconde variante d'un dispositif injecteur de spins.

### EXPOSÉ DÉTAILLÉ DE MODES DE RÉALISATION PARTICULIERS

L'un des objectifs de la présente demande est de faciliter la fabrication d'un dispositif permettant d'injecter des spins polarisés dans un matériau, lorsqu'il est connecté à une source de courant. Ce type de dispositif est également nommé un dispositif injecteur de spins.

Un procédé de fabrication est facilité lorsqu'il est adaptable aux contraintes industrielles, c'est-à-dire, facile, et/ou rapide, et/ou économique à mettre en oeuvre, tout en étant reproductible à grande échelle.

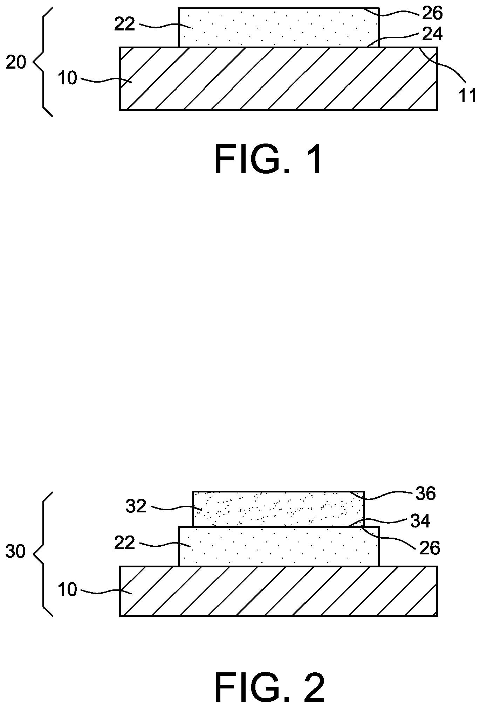

Un dispositif injecteur de spins 30 comporte un premier matériau, nommé substrat 10, électriquement conducteur et possédant des propriétés magnétiques. Une première face 11 du substrat 10 est en contact avec l'environnement extérieur et possède des propriétés magnétiques de type ferromagnétique et/ou ferrimagnétique et/ou antiferromagnétique (figure 1).

La première face 11 du substrat peut par exemple comporter ou être à base d'oxyde(s), et/ou de nitrite(s), et/ou de carbure(s), ou à base de cobalt, et/ou de fer, et/ou de nickel. L'expression « à base de » définit une proportion volumique supérieure ou égale à 5% ou 10% ou 50% ou 90% des éléments constituant ladite première face 11 et/ou le substrat 10.

La première face du substrat 10 peut être structurée, de préférence cristallisée, de manière à favoriser des états polarisés en spin au niveau de sa surface, pour une gamme d'énergie comprise entre -1eV<E-EF<+1eV, et susceptibles de se coupler électroniquement aux états de la couche de protection 22 décrite ci-après.

Lorsque la première face du substrat comporte du cobalt, celle-ci peut avoir une structure cristalline de type cubique face centrée (cfc), l'orientation des plans cristallographiques étant définie par les indices de Miller suivants(001).

Le substrat 10, ainsi que la couche de protection 22, sont élaborés par dépôt sous vide selon l'état de l'art industriel (pulvérisation cathodique, dépôt par faisceau d'électrons, sublimation thermique, etc...). La qualité du vide de base du bâti (inférieur à 1.10⁻⁸mbar), ainsi que le faible temps écoulé entre la fin du dépôt du substrat 10 et le début de la couche de protection 22, peuvent améliorer la qualité chimique de l'interface 24 qui en résulte. De préférence, la première face 11 est de surface plane.

Le procédé de fabrication peut comporter une seconde étape de recouvrement, au moins en partie, de la première face 11 par une couche intermédiaire, appelée couche de protection 22. On obtient alors un dispositif intermédiaire 20.

La couche de protection 22 peut être amorphe ou cristallisée et son épaisseur, selon une direction perpendiculaire ou sensiblement perpendiculaire à la première face 11, peut être supérieure ou égale à 1 monocouches et inférieure à 8 monocouches, ou bien comprise entre 1 et 3 monocouches d'atomes composant ladite couche, de préférence de l'ordre de 2 monocouches. Une monocouche est de préférence parallèle ou sensiblement parallèle à la première face 11.

La couche de protection 22 peut être composée par un ou une combinaison de métaux nobles, comme par exemple Au, et/ou Cu, et/ou Ag, ou tout métal présentant une faible réactivité à l'air et à l'eau. De préférence, la couche de protection 22 est paramagnétique et peut comporter une forte susceptibilité magnétique.

La face 26, en vis-à-vis de la face 24 de la couche de protection 22 en contact avec la première face 11 du substrat 10, peut être recouverte par un troisième matériau, formant une couche supérieure 32 (figure 2). On obtient alors un dispositif injecteur de spins 30.

De préférence, la couche supérieure 32 est de nature organique, par exemple de même nature que les couches organiques pour former des injecteurs de spins (Phys. Rev. Lett.105, 077201 (2010)).

De préférence, des liaisons chimiques s'établissent entre la face 26 de la couche de protection 22 et la face 34 de la couche supérieure 32 afin de mieux imprimer le champ d'échange indirect, et/ou la densité d'état polarisée en spin provenant de l'état quantifie dans la couche de protection, sur les sites atomiques du premier plan d'atomes de la couche supérieure.

L'un des avantages de l'invention est, du fait de la présence de la couche de protection 22 sur la face 11, que la composition de la couche organique peut être plus variée. Elle peut comporter des molécules qui se dégraderaient lors d'une élaboration sous vide. Elle peut même comporter des éléments qui dégraderaient potentiellement les performances spintroniques de la face 11 au contact direct de celle-ci. Par exemple, la couche supérieure 32 peut être composée par l'un ou une combinaison des éléments suivants : tris(8-hydroxyquinoléine)aluminium(III) (Alq3), porphyrine, phthalocyanine (Pc), 5,6,11,12-tétraphénylnaphthacène (rubrène), dianhydride pérylène-3,4,9,10-tétracarboxylique (PCTDA), tétracyanoéthylène (TCNE), tétrathiafulvalène (TTF), tétracyanoquinodi-méthane (TCNQ), Fe-phénanthroline, métallogrilles supramoléculaires (Angew. Chem. Int. Ed.2004, 43, 3644], nanotubes de carbone, graphène).

Son épaisseur, selon une direction perpendiculaire ou sensiblement perpendiculaire à la première face 11 du substrat 10, peut être supérieure à 1 plan moléculaire et inférieure à 1000 nm, ou bien comprise entre 1 et 3 plans moléculaires, de préférence de l'ordre de 2 plans moléculaires.

Avantageusement, la formation de la couche supérieure n'est pas limitée par des contraintes particulières, plus précisément à la préservation de l'état de surface de la face 11. De ce fait, la couche supérieure 32 peut être formée par l'une des techniques suivantes : sublimation thermique, évidemment et comme exemple d'une technique « sèche », mais aussi toute technique 'humide' telle que le drop-casting, spin-coating, Langmuir-Blodgett (A. Ulman, An Introduction to Ultrathin Organic Films From Langmuir-Blodgett to Self-Assembly, Academic Press, Inc.: San Diego (1991)).La plupart de ces techniques sont déjà employées au niveau industriel, elles sont donc simples à mettre en oeuvre et peu coûteuses.

A présent, plusieurs variantes des procédés de réalisation précédents vont être décrites.

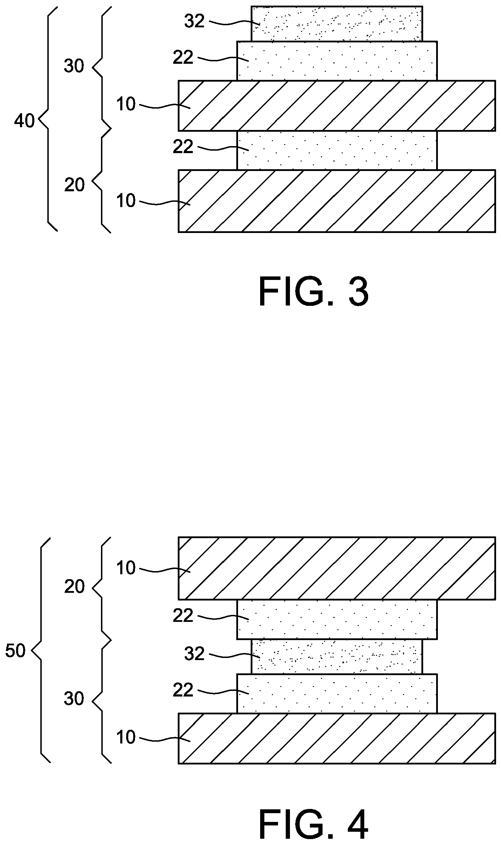

Selon une première alternative, un dispositif injecteur de spins 30 peut être placé au-dessus d'un dispositif intermédiaire 20 (figure 3). Eventuellement, la couche de protection 22 du dispositif intermédiaire 20 peut être en contact avec le substrat 10 du dispositif injecteur de spins.

Cette couche de protection 22 peut être substituée par une couche non-conductrice, permettant un transport diffusif. Dans ce cas on peut par exemple utiliser un substrat 10 tel que Co et une couche de protection 22 telle que Si ou GaAs. La couche de protection non-conductrice 22 peut aussi permettre le transport par effet tunnel de spins polarisés entre les deux substrats 10 du dispositif 40. Dans ce cas, on peut par exemple utiliser des substrats 10 tels que Co ou Ni₈₀Fe₂₀ et des couches de protection 22 telles que l'Al₂O₃ (Fert, Nobel Lectures 2008 Angew. Chem. Int. Ed.2008, 47, 5956 - 5967) ou encore SiO₂ (PHYSICAL REVIEW B73, 172402 (2006]). De préférence, le substrat 10 du dispositif injecteur de spins 30 est moins coercitif que le substrat 10 du dispositif intermédiaire 20, de sorte qu'il soit possible d'obtenir les états parallèles et antiparallèles d'aimantation des deux substrats 10, grâce au transfert de spin par effet torque, ce qui reflète l'action de la quantité de mouvement de spin du courant polarisé (avec pour référentiel celui de la couche de plus fort champ coercitif) sur l'aimantation de la couche de plus faible champ coercitif (Fert, Nobel Lectures 2008 Angew. Chem. Int. Ed.2008, 47 , 5956 - 5967f).

Ainsi, le dispositif intermédiaire 20 peut influencer ou contrôler le comportement du dispositif injecteur de spins 30, et en particulier le référentiel d'aimantation de la couche supérieure 32, en contrôlant l'aimantation de celui-ci via la direction de propagation du courant polarisé au travers du dispositif 40.

L'agencement représenté en figure 3, offre l'avantage de pouvoir contrôler la polarisation en spin du courant électrique traversant le dispositif injecteur de spins, soit de façon statique, soit de façon dynamique dans le domaine fréquentiel des Gigahertz. Dans le second cas, ceci reflète l'action du moment cinétique de spin sur le référentiel d'aimantation du substrat moins coercitif, qui entre alors en précession dans ce domaine de fréquence (Fert, Nobel Lectures 2008 Angew. Chem. Int. Ed.2008, 47, 5956 - 5967).

Selon une seconde alternative, un dispositif intermédiaire 20 peut être assemblé avec un dispositif injecteur de spins 30, de sorte à former un dispositif à effet tunnel 50, comportant une couche organique 32 entre deux substrats 10 conducteurs et magnétiques (figure 4). Lorsque la couche supérieure 22 est organique, le dépôt des couches métalliques sur cette couche peut s'effectuer à froid afin d'améliorer la qualité structurale et chimique de la couche supérieure 22.

Les procédés précédents peuvent comporter une étape consistant à relier électriquement les couches périphériques des dispositifs 30, 40 et 50, avec un dispositif générateur de courant électrique. Le générateur peut être mis en marche pour permettre le passage d'un courant polarisé en spins à travers la couche de protection 22 et la couche supérieure 32. En faisant passer un courant électrique suffisant au travers des dispositifs 40 et 50, il sera possible de modifier l'orientation relative d'aimantation des couches ferromagnétiques. De préférence, plus de 5% ou 10% ou 50% ou 70% ou supérieur à 70% des électrons traversant ces couches ont le même type de spin. Ce taux de polarisation étant maintenu pour des températures d'utilisation du dispositif supérieures à -50°C, ou 0°C, ou 50°C, ou 150°C, ou 250°C ou 500°C.

Les procédés précédents se distinguent notamment de l'état de la technique, par l'interposition d'une couche de protection 22 entre un substrat 10 et une couche supérieure 32 (figures 2, 3 et 4). La couche de protection 22 a au moins l'une des fonctions suivantes :
- protéger la première face 11 du substrat 10 de tous phénomènes d'oxydation et/ou de contamination ;
- et/ou perturber le moins possible les propriétés magnétiques du substrat 10 et/ou de la première face 11 ;
- et/ou favoriser l'hybridation de la couche supérieure 32 à sa surface 26, de sorte à permettre à la première face 11 du substrat 10 de polariser d'au moins 5% ou 10% ou 50% ou 70% ou supérieur à 70% la première couche atomique constituant la face 34 de la couche supérieure, en contact avec la couche de protection 22 ;
- et/ou contrôler les effets de couplage magnétique entre le substrat 10 et la couche supérieure 32.

De préférence, la couche de protection 22 est de nature à ne pas être dégradée par exposition à l'air et/ou à l'eau. Elle peut donc être composée par des métaux nobles.

Le choix des matériaux employés pour réaliser les dispositifs précédents (30, 40, 50), peut être fait en fonction des propriétés de la première face 11 du substrat et/ou de la couche de protection 22 et/ou de la couche supérieure 32.

Lorsque la couche de protection est composée à partir d'un alliage artificiel.

Le choix de l'épaisseur de la couche de protection 22 peut être fait en fonction de sa composition et de la composition de la face 11 en contact avec ladite couche (J. Phys.: Condens. Matter 14(2002) R169-R193 ; Applied Surface Science, Volumes 162-163, 1 August 2000, Pages 78-85 ; une réf plus généraliste : Nanomagnetism: Ultrathin Films, Multilayers and Nanostructures Vol. 1 Chap. 3 p. 61 (2006)).

**Tableau 1**

| Composition de la première face 11 | Composition de la couche de protection 22 | Epaisseur de la couche de protection 22 en monocouches (MC) ou Angström (A) |
|---|---|---|
| Fe (100) | Ag | 2.37±0.07MC |
| | | ou 4,85±0.14A |
| | | 5.73±0.05MC |
| | | ou 11,72±0.1A |
| Fe (100) | Au | 2.48±0.05MC |
| | | ou 5,06±0.1A |
| | | 8.6±0.3MC |
| | | ou 17,54±0.2A |
| Co (100) | Cu | 2,67MC |
| | | ou 4,8A |
| | | 5,88MC |
| | | ou 10,6A |

Ce choix d'épaisseur, qui doit tenir compte des contraintes d'épitaxie des couches 10 et 20 sur le substrat initial, mais aussi de l'accumulation de phase précise à l'interface entre la couche de protection 22 et la couche supérieure 32, peut aussi être optimisé afin de tenir compte de la température de fonctionnement du dispositif (Rep. Prog. Phys. 65(2002) 99-141). L'épaisseur des couches de protection divulguées dans le tableau 1 peut avoir une valeur multiple desdites valeurs, afin de favoriser le phénomène de couplage magnétique entre la première face 11 et la couche supérieure 32 (Physical Review Letter, 80, 1754 (1998). Ce phénomène demeure jusqu'à des épaisseurs de la couche de protection de 130 monocouches (Applied Surface Science, Volumes 162-163, 1 August 2000). Cependant, l'intensité du couplage d'échange diminue lorsque l'épaisseur augmente (Nanomagnetism: Ultrathin Films, Multilayers and Nanostructures Vol 1 Chap. 3 p. 61 (2006)). De préférence, l'épaisseur de la couche de protection, selon les critères énoncés précédemment, demeurera ainsi faible.

Le tableau 1 présente quelques exemples concrets de la paire substrat 10 / couche de protection 22. Pour peu que la couche de protection ne soit pas dégradée au contact de l'air et/ou de l'eau, toute paire remplissant par ailleurs certaines conditions de spintronique (couplage d'échange intercouches, états de puits quantifiés polarisés en spin (Fert, Nobel Lectures 2008 Angew. Chem. Int. Ed.2008, 47, 5956 - 5967, Nanomagnetism: Ultrathin Films, Multilayers and Nanostructures Vol 1 Chap. 3 p. 61 (2006)) peut être utilisée. Citons par exemple comme substrats 10 l'un des éléments suivants : Fe(100), Fe(111), Co(100), Co(111), Ni(100), Ni(111), hcp Co(0001), associé à une couche de protection 22 composée de l'un des éléments suivants : Ag(100), Ag(111), Cu(100), Cu(111), Au(100), Au(111).

Les procédés de fabrication précédents offrent notamment les avantages suivants :
- le substrat 10, une fois recouvert par la couche de protection 22, peut être stocké ou transféré dans des environnements oxydants ou humides, sans que les propriétés d'aimantation de sa première face 11 ne soient diminuées ;
- le dépôt de la couche supérieure sur le dispositif intermédiaire 20 peut être effectué dans des environnements à atmosphère oxydante ou de nature à dégrader les propriétés spintroniques du substrat 10 et de sa face supérieure 11 ;
- la couche supérieure 32, dont la nature chimique aurait pu, au contact direct avec le substrat 10, dégrader les propriétés de la surface 11 du substrat 10, peut être à présent intégrée dans un dispositif de spintronique grâce à la couche de protection 22 ;
- les propriétés spintroniques de la surface 11 du substrat 10 peuvent être qualitativement (c'est-à-dire en termes de la présence d'une polarisation de spin émanant d'un référentiel de spin contrôlée par l'aimantation du substrat 10) déportées sur la couche supérieure 32, permettant au substrat 10 de contrôler spintroniquement une couche supérieure se trouvant dans un environnement autrement néfaste aux propriétés spintroniques de la surface 11 du substrat 10.

La présente demande porte également sur les dispositifs obtenus à partir des procédés de fabrication précédents.

Un premier dispositif est un injecteur de spins 30, comportant une couche intermédiaire 20 intercalée ou séparant un substrat 10 et une couche supérieure 32 (figure 2).

Un second dispositif 40 est une couche organique à pilotage spintronique déporté, comportant un injecteur de spins 30 placé au-dessus d'un dispositif intermédiaire 20 (figure 3).

Un troisième dispositif 50 est une jonction de spintronique organique protégée. Celui-ci comporte au moins un injecteur de spins 30, dont la face 36 de la couche supérieure 32, en vis-à-vis et opposée à la face 26 de la couche de protection, est recouvert par un élément conducteur et magnétique, comme par exemple le substrat 10. De préférence, la couche intermédiaire 32 est séparée des deux substrats 10 du dispositif 50 par une couche de protection 22 (figure 4).

Les caractéristiques de ces dispositifs sont identiques ou semblables aux caractéristiques mentionnées lors de leurs procédés de fabrication.

Les éléments externes et opposés des dispositifs précédents (10, 32) peuvent être électriquement connecté à une source d'intensité, de sorte à permette à un courant électrique de traverser la couche supérieure 32.

Avantageusement, ces dispositifs permettent de contrôler l'aimantation, et ainsi le référentiel de polarisation de spin, d'une couche supérieure 32 grâce à un substrat magnétique 10 protégé de la couche supérieure 32, ou encore de l'environnement (air, eau) de la couche supérieure 32. L'utilisation d'une couche de protection métallique permet à ces dispositifs d'être faiblement résistifs.

Tous les dispositifs précédemment décrits peuvent comporter des moyens de contrôle du magnétisme du substrat 10 et/ou de la face 11 du substrat 10 permettant d'agir et de contrôler le référentiel magnétique du substrat 10. Ceci peut par exemple s'accomplir via des moyens permettant d'appliquer au substrat un champ magnétique, électrique, électromagnétique, une dilatation et/ou contraction mécanique du substrat, ou encore un changement de température du substrat magnétique. Le contrôle du magnétisme du substrat 10 permet alors de contrôler l'intensité et la polarisation en spin dans la couche supérieure 32.

## Revendications

1. Procédé de réalisation d'un dispositif injecteur de spins (30), comportant les étapes suivantes :
a) formation d'une couche de protection (22) métallique sur une face (11) d'un substrat (10), de manière à limiter ou empêcher l'oxydation et/ou la contamination de ladite face par son environnement, la face (11) du substrat (10) étant magnétique et conduisant le courant électrique, la couche de protection (22) étant par nature diamagnétique ou paramagnétique ;
b) formation d'une couche supérieure (32) sur la couche de protection (22), apte à favoriser une polarisation en spin d'états électroniques au voisinage du niveau de Fermi de l'interface entre la couche de protection (22) et la couche supérieure (32) selon une amplitude et un référentiel de spin définis par le magnétisme du substrat (10) et/ou de la face (11) du substrat (10), la couche supérieure (32) étant une couche organique dont un ou plusieurs sites moléculaires présentent, au contact avec la couche de protection (22), un moment paramagnétique **caractérisé par** un référentiel magnétique unique, figé dans l'espace et le temps et calqué sur un référentiel magnétique du substrat (10) et/ou de la face (11) du substrat (10).

2. Procédé de réalisation d'un dispositif injecteur de spins (30) selon la revendication 1, la couche de protection (22) étant composée par un ou plusieurs métaux nobles.

3. Procédé de réalisation d'un dispositif injecteur de spins (30), selon l'une des revendications précédentes, l'épaisseur de la couche de protection (22), selon une direction sensiblement perpendiculaire à la face (11) du substrat (10), étant comprise entre une et cent trente épaisseurs d'une couche d'atomes composant ladite couche de protection.

4. Procédé de réalisation d'un dispositif injecteur de spins (30) selon l'une des revendications précédentes, la couche supérieure (32) comportant au moins l'un des éléments suivants : carbone, azote, oxygène, fluor, bore, fer, cobalt, manganèse, cuivre, vanadium, zinc, magnésium, silicium.

5. Procédé de réalisation d'un dispositif injecteur de spins (30) selon l'une des revendications précédentes, la face (11) du substrat (10) comportant au moins l'un des éléments suivants : cobalt, et/ou nickel, et/ou fer, et/ou un alliage de Fer ou de Cobalt avec des métaux de type 4d ou/et 5d, et/ou un ou plusieurs oxydes magnétiques.

6. Procédé de réalisation d'un dispositif injecteur de spins (30) selon l'une des revendications précédentes, la face (11) du substrat (10) étant cristallisée.

7. Procédé de réalisation d'un dispositif injecteur de spins (30) selon l'une des revendications 1 à 5, la face (11) du substrat (10) étant amorphe.

8. Procédé de réalisation d'un dispositif injecteur de spins (30) selon l'une des revendications précédentes, comportant en outre la réalisation de moyens de contrôle du magnétisme du substrat (10) et/ou de la face (11) du substrat (10).

9. Procédé de réalisation d'un dispositif (40, 50) comportant la mise en oeuvre d'un procédé de réalisation d'un dispositif injecteur de spins (30) selon l'une des revendications précédentes, et dans lequel le dispositif injecteur de spin (30) est connecté à un dispositif intermédiaire (20) comportant une deuxième couche de protection (22) disposée sur un deuxième substrat (10), la deuxième couche de protection (22) du dispositif intermédiaire (20) étant disposée contre le substrat (10) ou la couche supérieure (32) du dispositif injecteur de spin (30).

10. Procédé de réalisation selon l'une des revendications précédentes, dans lequel les couches externes et opposées (10, 32) du dispositif (30, 40, 50) sont connectées à un dispositif générateur de courant.

11. Procédé de réalisation selon la revendication 10, dans lequel le dispositif générateur de courant étant apte à délivrer un courant électrique polarisé destiné à traverser au moins la couche de protection (22) du dispositif injecteur de spins (30) en étant polarisé à au moins 10 % pour une température de fonctionnement supérieure à -50°C.

## Patentansprüche

1. Verfahren zur Realisierung einer Spin-Injektor-Vorrichtung(30), aufweisend die folgenden Schritte:
a) Bilden einer metallischen Schutzschicht (22) auf einer Fläche (11) eines Substrats (10), um die Oxidation und/oder die Kontamination der besagten Fläche durch deren Umgebung zu begrenzen oder zu verhindern, wobei die Fläche (11) des Substrats (10) magnetisch ist und elektrischen Strom leitet, wobei die Schutzschicht (22) von Natur aus diamagnetisch oder paramagnetisch ist,
b) Bilden einer oberen Schicht (32) auf der Schutzschicht (22), die imstande ist, eine Spin-Polarisation elektrischer Zustände zu begünstigen benachbart zu dem Fermi-Niveau der Verbindungszone zwischen der Schutzschicht (22) und der oberen Schicht (32) gemäß einer Amplitude und einem Spin-Bezugssystem, die definiert sind durch den Magnetismus des Substrats (10) und/oder der Fläche (11) des Substrats (10), wobei die obere Schicht (32) eine organische Schicht ist, von der ein oder mehrere molekulare Gebiete, im Kontakt mit der Schutzschicht (22), ein paramagnetisches Moment haben, das charakterisiert ist durch ein eindeutiges magnetisches Bezugssystem, das fest im Raum und in der Zeit ist und auf ein magnetisches Bezugssystem des Substrats (10) und/oder der Fläche (11) des Substrats (10) übertragen ist.

2. Verfahren zur Realisierung einer Spin-Injektor-Vorrichtung (20) gemäß Anspruch 1, wobei die Schutzschicht (22) von einem oder mehreren Edelmetallen gebildet ist.

3. Verfahren zur Realisierung einer Spin-Injektor-Vorrichtung (30) gemäß einem der vorhergehenden Ansprüche, wobei die Dicke der Schutzschicht (22) entlang einer Richtung im Wesentlichen senkrecht zu der Seite (11) des Substrats (10) zwischen einer und 130 Dicken einer Schicht von Atomen beträgt, welche die besagte Schutzschicht bilden.

4. Verfahren zur Realisierung einer Spin-Injektor-Vorrichtung (30) gemäß einem der vorhergehenden Ansprüche, wobei die obere Schicht (32) wenigstens eines der folgenden Elemente aufweist: Kohlenstoff, Stickstoff, Sauerstoff, Flur, Bor, Eisen, Kobalt, Mangan, Kupfer, Vanadium, Zink, Magnesium, Silizium.

5. Verfahren zur Realisierung einer Spin-Injektor-Vorrichtung (30) gemäß einem der vorhergehenden Ansprüche, wobei die Seite (11) des Substrats (10) aufweist wenigstens eines der folgenden Elemente: Kobalt und/oder Nickel und/oder Eisen und/oder eine Eisen- oder Kobalt-Legierung mit Metallen des Typs 4d und/oder 5d, und/oder ein oder mehrere magnetische Oxide.

6. Verfahren zur Realisierung einer Spin-Injektor-Vorrichtung (30) gemäß einem der Ansprüche 1 bis 5, wobei die Seite (11) des Substrats (10) kristallin ist.

7. Verfahren zur Realisierung einer Spin-Injektor-Vorrichtung (30) gemäß einem der Ansprüche 1 bis 5, wobei die Seite (11) des Substrats (10) amorph ist.

8. Verfahren zur Realisierung einer Spin-Injektor-Vorrichtung (30) gemäß einem der vorhergehenden Ansprüche, ferner aufweisend das Realisieren von Mitteln zur Steuerung des Magnetismus des Substrats (10) und/oder der Seite (11) des Substrats (10).

9. Verfahren zur Realisierung einer Vorrichtung (40, 50), aufweisend das Durchführen eines Verfahrens zur Realisierung einer Spin-Injektor-Vorrichtung (30) gemäß einem der vorhergehenden Ansprüche, wobei die Spin-Injektor-Vorrichtung (30) mit einer Zwischen-Vorrichtung (20) verbunden wird, die eine zweite Schutzschicht (22) aufweist, die auf einem zweiten Substrat (10) angeordnet ist, wobei die zweite Schutzschicht (22) der Zwischen-Vorrichtung (20) gegen das Substrat (10) oder die obere Schicht (32) der Spin-Injektor-Vorrichtung (30) angeordnet ist.

10. Verfahren zur Realisierung gemäß einem der vorhergehenden Ansprüche, wobei die äußeren, entgegengesetzten Schichten (10, 32) der Vorrichtung (30, 40, 50) mit einer Stromerzeugungsvorrichtung verbunden sind.

11. Verfahren zur Realisierung gemäß Anspruch 10, wobei die Stromerzeugungsvorrichtung imstande ist, einen polarisierten elektrischen Strom zu liefern, der dazu bestimmt ist, wenigstens die Schutzschicht (22) der Spin-Injektor-Vorrichtung (30) zu durchqueren, wobei er um wenigstens 10% polarisiert ist für eine Betriebstemperatur größer als -50°C.

## Claims

1. A method for manufacturing a spin injector device (30), comprising the following steps of:
a) forming a metal protection layer (22) on a face (11) of a substrate (10), so as to restrict or prevent oxidation and/or contamination of said face by its environment, the face (11) of the substrate (10) being magnetic and electrically conductive, the protection layer (22) being of a diamagnetic or paramagnetic nature;
b) forming an upper layer (32) onto the protection layer (22), which is able to promote a spin bias of electronic sates in the vicinity of the Fermi level of the interface between the protection layer (22) and the upper layer (32) according to an amplitude and a spin referential frame which are defined by the magnetism of the substrate (10) and/or of the face (11) of the substrate (10), the upper layer (32) being an organic layer of which one or more molecular sites have, in contact with the protection layer (22), a paramagnetic moment **characterised by** a single magnetic referential frame, fixed in space and time and based on a magnetic referential frame of the substrate (10) and/or of the face (11) of the substrate (10).

2. The method for manufacturing a spin injector device (30) according to claim 1, wherein the protection layer (22) is made of one or several noble metals.

3. The method for manufacturing a spin injector device (30) according to one of the preceding claims, wherein the thickness of the protection layer (22), along a direction substantially perpendicular to the face (11) of the substrate (10), is between one and one hundred thirty thicknesses of an atom layer making up said protection layer.

4. The method for manufacturing a spin injector device (30) according to one of the preceding claims, wherein the upper layer (32) includes at least one of the following elements: carbon, nitrogen, oxygen, fluorine, boron, iron, cobalt, manganese, copper, vanadium, zinc, magnesium, silicon.

5. The method for manufacturing a spin injector device (30) according to one of the preceding claims, wherein the face (11) of the substrate (10) includes at least one of the following elements: cobalt, and/or nickel, and/or iron, and/or an iron or cobalt alloy with 4d and/or 5d type metals, and/or one or more magnetic oxides.

6. The method for manufacturing a spin injector device (30) according to one of the preceding claims, wherein the face (11) of the substrate (10) is crystallized.

7. The method for manufacturing a spin injector device (30) according to one of claims 1 to 5, wherein the face (11) of the substrate (10) is amorphous.

8. The method for manufacturing a spin injector device (30) according to one of the preceding claims, further including a manufacturing of means for controlling the magnetism of the substrate (10) and/or of the face (11) of the substrate (10).

9. A method for manufacturing a device (40, 50) including implementing a method for manufacturing a spin injector device (30) according to one of the preceding claims, and wherein the spin injector device (30) is connected to an intermediate device (20) including a second protection layer (22) provided on a second substrate (10), the second protection layer (22) of the intermediate device (20) being provided against the substrate (10) or the upper layer (32) of the spin injector device (30).

10. The manufacturing method according to one of the preceding claims, wherein the outer opposite layers (10, 32) of the device (30, 40, 50) are connected to a current generator device.

11. The manufacturing method according to claim 10, wherein the current generator device is able to output a biased electrical current for passing through at least the protection layer (22) of the spin injector device (30) by being biased to at least 10% for an operating temperature higher than -50°C.
